# NEUE EUROPÄISCHE PATENTSCHRIFT

(11) **EP 1 118 104 B2**
(45) Veröffentlichungstag und Bekanntmachung des Hinweises auf die Entscheidung über den Einspruch: **25.11.2009**
(45) Hinweis auf die Patenterteilung: 19.10.2005
(21) Anmeldenummer: 00951498.5
(22) Anmeldetag: 11.08.2000
(51) Int. Cl.: H01L 21/00, H05K 13/04

(54) **MONTAGEVORRICHTUNG**
ASSEMBLY DEVICE
DISPOSITIF DE MONTAGE

(30) Priorität: 11.08.1999 EP 99115834
(43) Veröffentlichungstag der Anmeldung: 25.07.2001
(73) Patentinhaber: Siemens Electronics Assembly Systems GmbH & Co. KG, 81379 München (DE)
(72) Erfinder: PAJONK, Joachim, D-83714 Miesbach (DE); POGERT, Jörg, D-85521 Riemerling (DE); KRANICH, Jochen, D-82049 Pullach (DE); FISCHER, Jakob, D-82008 Unterhaching (DE)
(86) Internationale Anmeldenummer: PCT/EP2000/007837
(87) Internationale Veröffentlichungsnummer: WO 2001/013409

(56) Entgegenhaltungen:
- EP-A- 0 454 317
- EP-A- 0 582 086
- WO-A-98/37744
- US-A- 4 393 579
- US-A- 4 754 545
- US-A- 5 040 291
- "SUBSTRATE CARRIER ASSEMBLY FOR ROBOT OPERATIONS" IBM TECHNICAL DISCLOSURE BULLETIN, Bd. 33, Nr. 3A, 1. August 1990 (1990-08-01), Seite 259/260 XP000123928 ISSN: 0018-8689

## Beschreibung

Die vorliegende Erfindung betrifft eine Montagevorrichtung, insbesondere eine vollautomatische Montagevorrichtung zur Herstellung mikrosystemtechnischer Produkte sowie für Montageaufgaben in der Halbleiterindustrie, mit einem Montagetisch, mindestens einem Materialtransportsystem zum Transport der mit Bauteilen zu bestückenden Produkte, mindestens einem auf dem Montagetisch angeordnetem Transportsystem sowie mindestens eine senkrecht zu dem Transportsystem angeordnete und bewegbare Bauteiltransporteinheit mit mindestens einem Montagekopf, wobei die Bauteiltransporteinheit bzw. -einheiten auf einem oder mehreren, mittels des Transportsystems parallel zur Richtung des Transports der mittels des oder der Materialtransportsysteme bewegbaren und mit den Bauteilen zu bestückenden Produkte verfahrbaren Portalen angeordnet sind.

Derartige Montagevorrichtungen sind aus dem Stand der Technik, zum Beispiel aus der US 4 754 545 A bekannt. Bekannte gattungsgemäße Montagevorrichtungen lassen sich in drei Hauptkategorien einteilen: Bestücker zur Herstellung von Elektronikkomponenten, Montageautomaten für die Halbleiterindustrie und Laborgeräte für die Montage von Mustern mikrosystemtechnischer Demonstratoren. Derartige Montagevorrichtungen weisen aber vielfältige Nachteile insbesondere für die Herstellung von Mikrosystemen auf.

So sind sogenannte Bestücker auf Geschwindigkeit, d. h. auf einen möglichst hohen Durchsatz mit Bestückungszahlen bis zu 100.000 BE/h optimiert. Allerdings weisen sie den Nachteil auf, daß die Erhöhung der Geschwindigkeit mit einer reduzierten Montagegenauigkeit einher geht. Dies bedeutet, daß derartige Montagevorrichtungen nur für ein sehr begrenztes Spektrum an Bauteilen, Substraten und Montageprozessen Verwendung findet. Der Einsatz von Bestückern ist für die Montage von Mikrosystemen insbesondere aus Genauigkeitsgründen und mangels Flexibilität nicht möglich.

Demgegenüber sind Montageautomaten für die Halbleiterindustrie, sogenannte Die-Bonder auf Prozesssicherheit, d. h. insbesondere auf eine relativ hohe Montagegenauigkeit, optimiert. Dabei ist eine Vielzahl von Die-Bonder-Ausführungen bekannt. Diese leiden aber an dem Nachteil, dass die angewandten und bisher bekannten Gestelltechniken in Kombination mit der zu realisierenden Montagebewegung entweder zu Lasten des Raumangebotes, d.h. der Beschränkung des auf einem Montagetisch verfügbaren Arbeitsraumes, gehen oder die Umrüstbarkeit beziehungsweise Konfigurierbarkeit und die Zugänglichkeit der Vorrichtung erschwert beziehungsweise beschränkt ist. Zudem ist eine ausreichende Steifigkeit der bekannten Die-Bonder-Aufbauten zur Erreichung hoher Montagegenauigkeiten bei entsprechend hohen Verfahrgeschwindigkeiten zur Erreichung hoher Durchsatzzahlen bisher nicht zufriedenstellend gelöst worden.

Aus der WO 9837744 A1 ist eine Vorrichtung zum Herstellen von elektrischen Baugruppen, insbesondere zum Bestücken von Leiterplatten mit elektrischen Bauelementen bekannt. Die Vorrichtung besitzt dabei ein Chassis mit zwei zueinander im Wesentlichen parallel angeordneten Längsführungen zur Aufnahme von verfahrbaren, balkenartigen Wagen mit Querträgern. An den Querträgem sind verfahrbare Bearbeitungsköpfe angeordnet. Aus der EP 0 454 317 A2 und der US 5 040 291 A sind ebenfalls Montagevorrichtungen mit portalartigem Aufbau bekannt.

Bekannte Montagevorrichtungen aus der Elektronik- und Halbleiterindustrie genügen aber weder den kombinierten Anforderungen nach Montagepräzision bei gleichzeitig hohem Durchsatz, noch sind sie so flexibel gestaltet, dass eine rasche Umrüstbarkeit auf verschiedene Prozessanforderungen und Materialpräsentationen erfolgen kann.

Es ist daher Aufgabe der vorliegenden Erfindung, eine gattungsgemäße Montagevorrichtung bereitzustellen, die einerseits eine hohe Montagepräzision, einen hohen Durchsatz sowie eine leichte Umrüstbarkeit gewährleistet.

Gelöst wird diese Aufgabe durch eine Montagevorrichtung mit den Merkmalen gemäß dem Anspruch 1.

Vorteilhafte Ausgestaltungen sind in den Unteransprüchen beschrieben.

Bei einer erfindungsgemäßen Montagevorrichtung ist eine Bauteiltransporteinheit beziehungsweise -einheiten auf einem oder mehreren, mittels eines Transportsystems parallel zur Richtung des Transports der mittels des oder der Materialtransportsysteme bewegbaren und mit Bauteilen zu bestückenden Produkte verfahrbaren Portalen angeordnet. Durch die Anordnung von Portal und Materialtransportsystem ist es möglich, für den Bauteiltransport überwiegend nur den Montagekopf zu bewegen. Das Portal selbst führt dabei in bestimmten Montage-Modi nur eine kurze Ausgleichsbewegung durch, so dass relativ geringe Massen zu bewegen sind. Dadurch kann der Montagekopf mit größerer Geschwindigkeit bewegt werden, was wiederum zu größeren Durchsätzen und einer höheren Montagepräzision führt. Weiterhin ist es möglich, größere Transportbewegungen durch Verfahren der Portale durchzuführen, so dass die gesamte zur Verfügung stehende Oberfläche des Montagetisches abgefahren werden kann, und somit eine hohe Bauteil- und Substratvariation ermöglicht wird. Des Weiteren wird es durch das oder die senkrecht zur Materialtransportrichtung angeordneten und parallel zu diesen verfahrbaren Portalen möglich, dass sehr breite Materialien bzw. zu bestückende Produkte verarbeitet werden können. Alternativ dazu können gleichzeitig mehrere Materialtransporteinheiten in der Montagevorrichtung angeordnet sein, so dass die Bestückungsgeschwindigkeit auch hierdurch deutlich erhöht werden kann. Durch den Portalaufbau wird zudem erreicht, dass der Schwerpunkt des Transportsystems beziehungsweise aller bewegbaren Elemente der Montagevorrichtung relativ nahe an der Oberfläche eines Montagetisches liegt. Dadurch wird ein noch schwingungsärmerer Aufbau der Montagevorrichtung erreicht, so dass eine sehr hohe Montagegenauigkeit gewährleistet ist. Durch den Portalaufbau bleibt das Platzangebot auf dem Montagetisch erhalten, was für die Zugänglichkeit, Umrüstbarkeit und freie Konfigurierbarkeit vorteilhaft ist. Erfindungsgemäß weist die Montagevorrichtung ein Transportsystem auf, dass aus einer in einem Maschinengestell der Montagevorrichtung parallel zur Richtung des Transports der mittels des oder der Materialtransportsysteme bewegbaren, mit den Bauteilen zu bestückenden Produkte angeordneten Schiene besteht, wobei mindestens ein Portalträger senkrecht in die Schiene eingreift, so dass das oder die Portale verfahrbar sind. Dadurch werden erfindungsgemäß Reaktionskräfte aus der Bewegung der Bauteiltransporteinheit optimiert abgeleitet. Entstehende Vibrationen werden durch den verbesserten Kraftfluss minimiert. Zudem weist die Montagevorrichtung erfindungsgemäß ein Portal auf, bei dem das Portal bzw, der Portalträger an dem der Schiene gegenüberliegenden Ende ein Auflager aufweist, wobei das Auflager auf einem im Maschinengestell ausgebildeten und zur Schiene parallel angeordneten Gegenlager zu liegen kommt. Dadurch wird das Platzangebot auf der Montageebene nochmals erweitert. Zudem steigen die Zugänglichkeit der Montagevorrichtung und deren freie Konfigurierbarkeit. Erfindungsgemäß weist das Transportsystem weiterhin zwei Portalantriebe auf. Obgleich die Verwendung eines einzigen Portalantriebes bereits zu hervorragenden Ergebnissen im Bereich der Montagegenauigkeit und Montagegeschwindigkeit führt, kann die Verwendung zweier Portalantriebe, die jeweils an einer Seite des Portals angeordnet sind, zu noch höheren Montagegenauigkeiten und Montagegeschwindigkeiten führen. Dies liegt darin begründet, dass der Portalschwerpunkt in der Regel exzentrisch zum Antriebssystem sitzt beziehungsweise die Lage des Portalschwerpunktes aufgrund sich ständig ändernder Lastverhältnisse zeitlich variabel ist. Diese Exzentrität beziehungsweise zeitliche Variabilität kann zu Unwuchten mit entsprechendem negativem Einfluss auf die Montage- bzw. Positioniergenauigkeit des Portals führen. Durch die Verwendung von zwei geregelten Portalantrieben ist gewährleistet, dass der Portalschwerpunkt immer zwischen den Antrieben sitzt und somit keine exzentrische Lage auftreten kann. Durch die Verwendung von zwei geregelten Portalantrieben kann zusätzlich erreicht werden, dass abhängig von der aktuellen Position des Portalschwerpunktes die Antriebsregelung adaptiv ausgelegt wird, so dass eine hohe dynamische Steifigkeit des Portalaufbaues erreicht wird. Somit ist es möglich, die Positionierung noch exakter vorzunehmen.

In einer weiteren vorteilhaften Ausgestaltung der erfindungsgemäßen Montagevorrichtung sind die Bewegungen mehrerer Portale untereinander synchronisierbar. Dadurch ist es möglich, die Produktionsgeschwindigkeit deutlich zu steigern. Durch eine dynamisch optimierte Synchronisierung mehrerer Portale in ihren jeweiligen Bewegungen kann eine deutliche Reduzierung der Maschinenschwingungen erreicht werden (dynamisches Wuchten), wodurch die Monategenauigkeit weiter gesteigert werden kann.

In einer weiteren vorteilhaften Ausgestaltung der Erfindung besteht der Montagekopf aus einem vertikal oder horizontal angeordneten Revolverkopf. Durch die Verwendung eines Revolverkopfes kann die Zahl der Transporthübe erheblich reduziert werden, wodurch die Transport-Nebenzeiten sinken und die Produktionsgeschwindigkeit wiederum erhöht werden kann.

Gemäß der Ausgestaltung der Erfindung sind mehrere Portale übereinander angeordnet. Eine derartige Anordnung erhöht die Anzahl der Montageebenen, was wiederum zu einer Erhöhung der Produktionsgeschwindigkeit und zu einer noch größeren Flexibilität in Bezug auf die Anwendungsbereiche der erfindungsgemäßen Montagevorrichtung führt.

Weitere Einzelheiten, Merkmale und Vorteile der Erfindung ergeben sich aus der folgenden Beschreibung eines zeichnerisch dargestellten Ausführungsbeispiels. Es zeigen:
- Figur 1: eine schematisch dargestellte Montagevorrichtung gemäß dem Stand der Technik mit einem Portal;
- Figur 2: eine schematisch dargestellte Montagevorrichtung gemäß Figur 1 mit dargestellten Portalantrieben;
- Figur 3: eine weitere Ausführungsform einer Montagevorrichtung gemäß dem Stand der Technik mit einem vertikal angeordneten Revolverkopf;
- Figur 4: eine weitere Ausführungsform einer Montagevorrichtung gemäß dem Stand der Technik mit einem horizontal angeordneten Revolverkopf;
- Figur 5: eine weitere Ausführungsform einer Montagevorrichtung mit zwei Portalen;
- Figur 6: eine Ausführungsform einer Montagevorrichtung mit einem Portal.

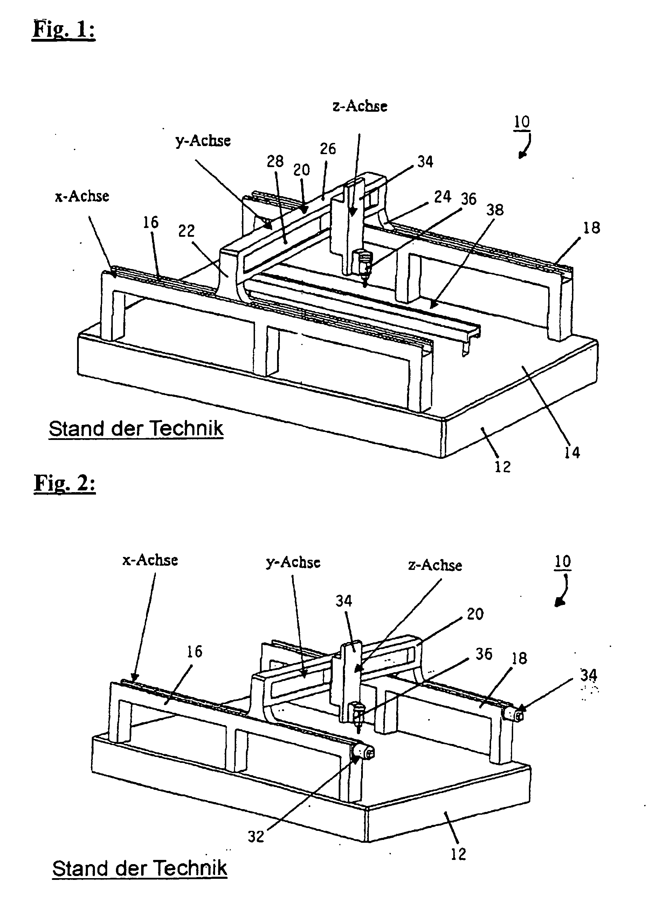

Die Figuren 1 bis 5 zeigen bekannte Montagevorrichtungen gemäß dem Stand der Technik.

Figur 1 zeigt eine erste Ausführungsform einer Montagevorrichtung 10 gemäß dem Stand der Technik, insbesondere zur Verwendung als vollautomatische Montagevorrichtung zur Herstellung mikrosystemtechnischer Produkte sowie die Ausführung von Montageaufgaben in der Halbleiterindustrie. Die Montagevorrichtung 10 weist einen Montagetisch 12 mit einer Montageebene beziehungsweise Tischebene 14 auf. Auf der Tischebene 14 ist ein Transportsystem 16, 18 angeordnet. Das Transportsystem 16, 18 besteht aus einem Schienensystem mit zwei parallel angeordneten Schienen 16, 18. Des weiteren erkennt man, dass die Schienen 16, 18 über der Tisch- beziehungsweise Montageebene 14 des Montagetisches 12 angeordnet sind. Es ist aber auch möglich, dieses Transportsystem 16, 18 in der Tischebene, d. h. auf dem Montagetisch, anzuordnen oder das Transportsystem 16, 18 direkt an das Maschinengrundgestell anzulenken, um eine optimierte Krafteinleitung auf tragende Maschinenteile zu erreichen.

Mit Hilfe des Transportsystems 16, 18 wird ein Portal 20 bewegt. Das Portal 20 besteht dabei aus einer ersten und einer zweiten Portalstütze 22, 24, die jeweils in die Schienen 16, 18 eingreifen und dort geführt sind. Die beiden Portalstützen 22, 24 sind mittels eines Portalträgers 26 miteinander verbunden. Der Portalträger 26 weist in seiner Längsrichtung eine längliche Eingriffsöffnung 28 auf, in die eine Bauteiltransporteinheit 34 eingreift und bewegbar geführt ist. An der Bauteiltransporteinheit 34 ist ein Montagekopf 36 beweglich und lösbar befestigt.

Man erkennt, dass das Portal 20 parallel zur Richtung des Materialtransports entlang der x-Achse verfahrbar ist. Der Materialtransport erfolgt dabei ebenfalls in Richtung der x-Achse und mit Hilfe eines Material-Transportsystems 38, das ebenfalls im Bereich der Montagebeziehungsweise Tischebene 14 angeordnet ist.

Es wird deutlich, dass die Ausrichtung des Transportsystems 16, 18 und die Richtung des Materialtransports die x-Achse, der senkrecht dazu ausgerichtete Portalträger 26 des Portals 20 die y-Achse und die zur y-Achse vertikale Bewegungsrichtung der Bauteiltransporteinheit 34 beziehungsweise des Montagekopfes 36 die z-Achse der räumlichen Anordnung der Montagevorrichtung 10 bilden. Dabei kann in Richtung der z-Achse entweder die gesamte Bauteiltransporteinheit 34 oder lediglich der Montagekopf 36 auf der Bauteiltransporteinheit 34 bewegt werden.

Figur 2 zeigt die Montagevorrichtung 10 gemäß Figur 1. Man erkennt zusätzlich die Anordnung eines ersten und zweiten Portalantriebs 30, 32, die jeweils in einer Schiene 16 beziehungsweise 18 des Transportsystems angeordnet sind.

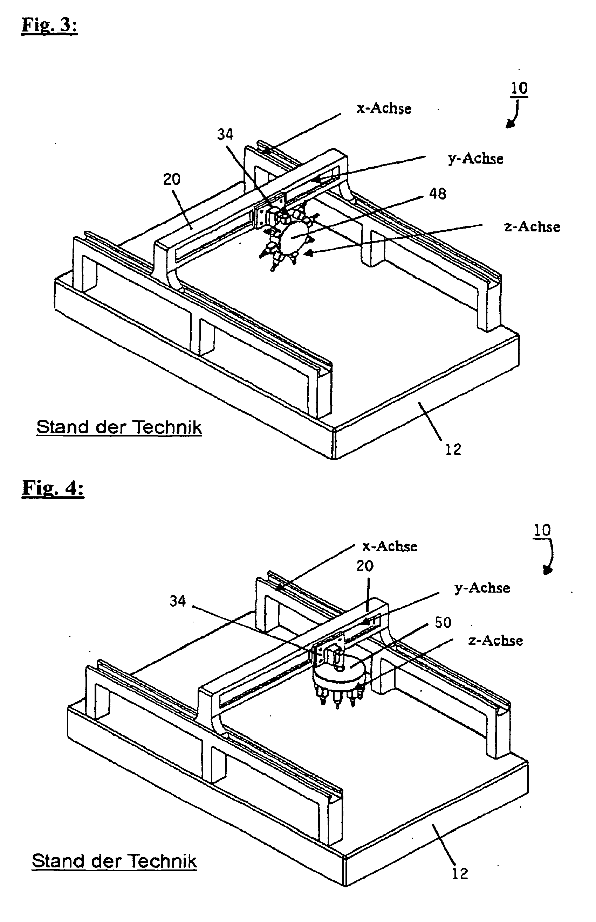

Die Figuren 3 und 4 zeigen jeweils weitere Ausführungsformen der Montagevorrichtung 10. Dabei ist der Montagekopf durch einen vertikal beziehungsweise horizontal angeordneten Revolverkopf 48, 50 ersetzt. Dabei bedeutet vertikale beziehungsweise horizontale Anordnung der Revolverköpfe 48, 50 die vertikale beziehungsweise horizontale Drehung der Revolverköpfe 48, 50 in Bezug auf die Montage- beziehungsweise Tischebene 14.

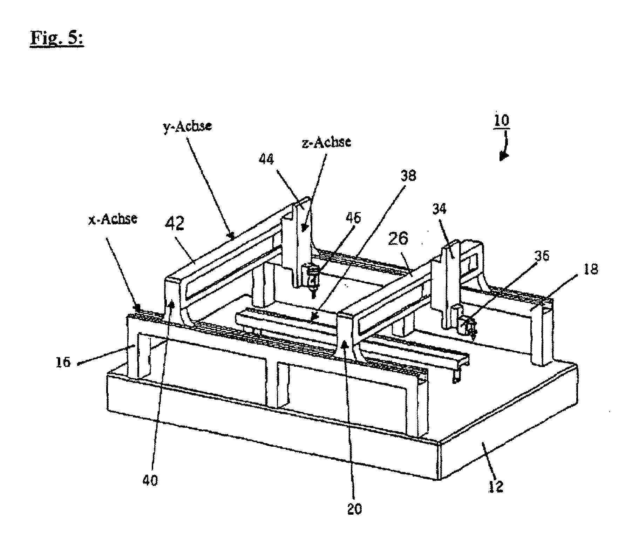

Figur 5 zeigt eine weitere Ausführungsform der Montagevorrichtung 10 mit zwei hintereinander angeordneten und verfahrbaren Portalen 20, 40 mit entsprechenden Portalträgern 26, 42. Die Bewegung der Portale 20, 40 ist dabei untereinander synchronisierbar. Es ist möglich, für die beiden Portale 20, 40 jeweils separate Portalantriebe oder auch einen gemeinsamen Portalantrieb vorzusehen. Des weiteren ist es möglich, dass die Portale 20, 40 eine unterschiedliche Höhe aufweisen, so dass unterschiedliche Montageebenen entstehen. Das dargestellte Ausführungsbeispiel zeigt allerdings eine Montagevorrichtung 10 mit zwei gleich ausgebildeten Portalen 20, 40.

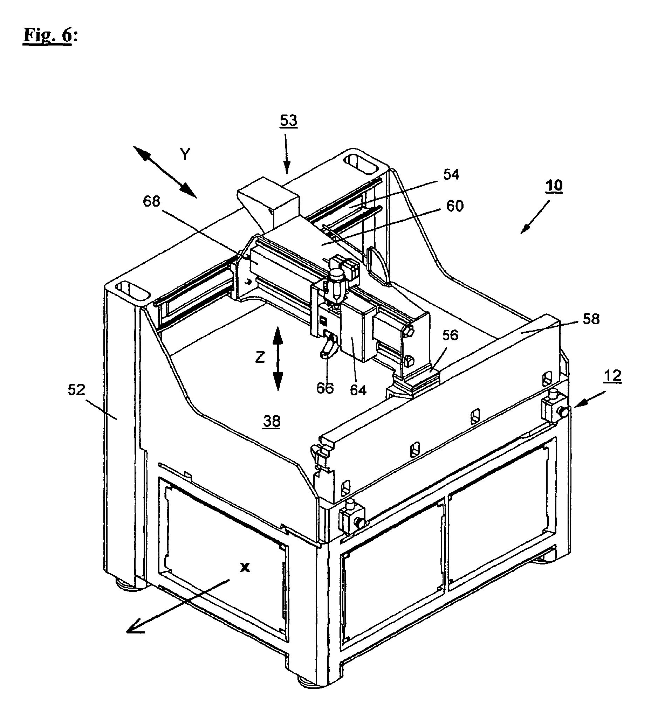

Figur 6 zeigt eine Ausführungsform einer Montagevorrichtung 10 mit einem Portal 60 und einem Transportsystem 53 zur Bewegung des Portals 60 parallel zur Richtung des Materialtransports, d.h. parallel zu der Bewegungsrichtung der mit Bauteilen zu bestückenden Produkte (x-Achse). Das Transportsystem 53 besteht dabei aus einer in einem Maschinengestell 52 der Montagevorrichtung 10 parallel zur Richtung des Transports (x-Achse) der mittels des oder der Materialtransportsysteme 38 bewegbaren, mit den Bauteilen zu bestückenden Produkte angeordneten Schiene 54. Ein Portalträger 68 des Portals 60 weist dabei ein weiteres Transportsystem zur Bewegung der Bauteiltransporteinheit 64 mit dem Montagekopf 66 auf und greift senkrecht (y-Achse, vgl. Fig. 5) in die Schiene 54 ein. Das Portal 60 ist in Richtung der x-Achse verfahrbar. Da das Portal 60 über die Schiene 54 senkrecht in das Gestell 52 eingreift, können alle Bewegungskräfte aus der Bewegung entlang der y-Achse des Bauteiltransportsystems 64 und des Montagekopfs 66 über das Maschinengestell 52 abgeleitet werden, wodurch sich günstige Verhältnisse bezüglich auftretender Maschinenschwingungen, insbesondere reduzierte Schwingungen aufgrund der genutzten Steifigkeit des Maschinengestells 52, einstellen. Das Portal 60 bzw. der Portalträger 68 weist dabei an dem der Schiene 54 gegenüberliegenden Ende ein Auflager 56 auf, welches auf einem im Maschinengestell 52 ausgebildeten und zur Schiene 54 parallel angeordneten Gegenlager 58 zu liegen kommt.

## Patentansprüche

1. Montagevorrichtung, insbesondere vollautomatische Montagevorrichtung zur Herstellung mikrosystemtechnischer Produkte sowie für Montageaufgaben in der Halbleiterindustrie,
- mit einem Montagetisch (12),
- mindestens einem Materialtransportsystem (38) zum Transport der mit Bauteilen zu bestückenden Produkte,
- mindestens einem auf dem Montagetisch (12) angeordnetem Transportsystem (53) sowie
- mindestens eine senkrecht zu dem Transportsystem (53) angeordnete und bewegbare Bauteiltransporteinheit (64) mit mindestens einem Montagekopf (66),
- wobei die Bauteiltransporteinheit bzw. -einheiten (64) auf einem oder mehreren, mittels des Transportsystems (53) parallel zur Richtung des Transports der mittels des oder der Materialtransportsysteme (38) bewegbaren und mit den Bauteilen zu bestückenden Produkte verfahrbaren Portal (60) angeordnet sind,
- **dadurch gekennzeichnet,**
- **dass** das Transportsystem (53) aus einer in einem Maschinengestell (52) der Montagevorrichtung (10) parallel zur Richtung des Transports der mittels des oder der Materialtransportsysteme (38) bewegbaren, mit den Bauteilen zu bestückenden Produkte angeordneten Schiene (54) besteht,
- wobei mindestens ein Portalträger (68, 70) senkrecht in die Schiene (54) eingreift, so dass das Portal (60) verfahrbar ist und so dass Bewegungskräfte aus der Bewegung entlang der y-Achse des Bauteiltransportsystems (64) und des Montagekopfs (66) über das Maschinengestell (52) optimiert abgeleitet werden,
- wobei das Portal (60) bzw. der Portalträger (68) an dem der Schiene (54) gegenüberliegenden Ende ein Auflager (56) aufweist, wobei das Auflagers (56) auf einem im Maschinengestell (52) ausgebildeten und zur Schiene (54) parallel angeordneten Gegenlager (58) zu liegen kommt und
- das Transportsystem (53) zwei Portalantriebe aufweist, die jeweils an einer Seite des Portal (60) angeordnet sind,
- wobei weiterhin oberhalb oder unterhalb des Portals (60) ein weiteres Portal mit einer Hauteiltransporteinheit zum bestücken der mit den Bauteilen zu bestückenden Produkte angeordnet ist.

2. Montagevorrichtung nach Anspruch 1, **dadurch gekennzeichnet, dass** die Ausrichtung des Transportssystems (53) die x-Achse, ein senkrecht dazu ausgerichteter Portalträger (68) des Portals (60) die y-Achse und eine zur y-Achse vertikale Bewegungsrichtung der Bauteiltransporteinheit (64) bzw. des Montagekopfs (66) die z-Achse der räumlichen Anordnung der Montagevorrichtung (10) bilden.

3. Montagevorrichtung nach einem der vorhergehenden Ansprüche, **dadurch gekennzeichnet, dass** die Bewegungen mehrerer Portale (60) untereinander synchronisierbar sind.

4. Montagevorrichtung nach einem der vorhergehenden Ansprüche, **dadurch gekennzeichnet, dass** der Montagekopf (66) aus einem vertikal oder horizontal angeordneten Revolverkopf besteht.

5. Montagevorrichtung nach einem der vorhergehenden Ansprüche, **dadurch gekennzeichnet, dass** drei oder mehr Portale übereinander angeordnet sind.

## Claims

1. Assembly device, in particular a fully-automated assembly device for the manufacture of microsystem technology products and for assembly tasks in the semiconductor industry,
- with an assembly table (12),
- at least one material transport system (38) for transporting the products which are to have components inserted into them,
- at least one transport system (53) arranged on the assembly table (12) together
- with at least one moveable component transport unit (64) with at least one assembly head (66) and arranged at right angles to the transport system (53),
- whereby the component transport unit or units (64), as applicable, is / are arranged on one or more drivable gantries (60) which can be moved by means of the transport system (53) parallel to the direction of transport of the products, which can be moved by means of the material transport system or systems (38) and into which components are to be inserted,
**characterised in that**
- the transport system (53) consists of a rail (54), arranged in a machine frame (52) of the assembly device (10) parallel to the direction of transport of the products, into which components are to be inserted, which can be moved by means of the material transport system or systems (38),
- whereby at least one gantry beam (68, 70) engages vertically in the rail (54), so that the gantry (60) can be driven and so that movement forces due to movements by the component transport system (64) and by the assembly head (66) along the y-axis are optimally dissipated through the machine frame (52),
- whereby the gantry (60) or the gantry beam (68), as applicable, has a bearing (56) at its opposite end from the rail (54), whereby the bearing (56) lies against a counterbearing (58) formed in the machine frame (52) and arranged parallel to the rail (54) and
- the transport system (53) has two gantry drives each of which is arranged at one side of the gantry (60),
- whereby a further gantry with a component transport unit for inserting the products which are to have components inserted into them is also arranged above or below the gantry (60).

2. Assembly device in accordance with claim 1,
**characterised in that**
the orientation of the transport system (53) defines the x-axis for the spatial arrangement of the assembly device (10), a gantry beam (68) of the gantry (60) which is perpendicular to this the y-axis, and vertical to this a direction of movement of the component transport unit (64) or of the assembly head (66) the z-axis.

3. Assembly device in accordance with one of the preceding claims
**characterised in that**
the movements of several gantries (60) can be synchronised with each other.

4. Assembly device in accordance with one of the preceding claims
**characterised in that**
the assembly head (66) consists or a turret head arranged vertically or horizontally.

5. Assembly device in accordance with one of the preceding claims
**characterised in that**
three or more gantries are arranged one above the other.

## Revendications

1. Dispositif de montage, en particulier dispositif de montage entièrement automatique de fabrication de produits de la technique des microsystèmes ainsi que pour des travaux de montage de l'industrie des semi-conducteurs, comportant
- une table de montage (12),
- au moins un système de transport de matériels (38) pour transporter les produits à équiper de composants,
- au moins un système de transport (53) disposé sur la table de montage (12), ainsi que
- au moins une unité de transport de composants (64) disposée perpendiculairement au système de transport (53) et mobile, équipée d'au moins une tête de montage (66),
- l'unité ou les unités de transport de composants (64) étant disposées sur un ou plusieurs portiques (60) déplaçables au moyen du système de transport (53) parallèlement à la direction de transport des produits déplaçables au moyen du ou des systèmes de transport de matériels (38) et à équiper des composants,
**caractérisé en ce que**
- le système de transport (53) se compose d'un rail (54) disposé dans un bâti de machine (52) du dispositif de montage (10) parallèlement à la direction de transport des produits déplaçables au moyen du ou des systèmes de transport de matériels (38) et à équiper des composants,
- au moins un support de portique (68, 70) s'engageant perpendiculairement dans le rail (54) si bien que le portique (60) est déplaçable et si bien que des forces de déplacement issues du mouvement le long de l'axe des y du système de transport de composants (64) et de la tête de montage (66) sont dérivées de façon optimisée au travers du bâti de machine (52),
- le portique (60) ou le support de portique (68) présentant un appui (56) à l'extrémité opposée au rail (54), l'appui (56) venant reposer sur une butée (58) formée dans le bâti de machine (52) et disposée parallèlement au rail (54) et
- le système de transport (53) présentant deux entraînements de portique disposés chacun d'un côté du portique (60),
- un autre portique avec une unité de transport de composants pour équiper les produits à équiper des composants étant en outre situé au-dessus ou en dessous du portique (60).

2. Dispositif de montage selon la revendication 1,
**caractérisé en ce que**
l'alignement du système de transport (53) forme l'axe des x, un support de portique (68) du portique (60) qui lui est perpendiculaire forme l'axe des y et une direction de mouvement, verticale par rapport à l'axe des y, de l'unité de transport de composants (64) ou de la tête de montage (66) forme l'axe des z de la disposition spatiale du dispositif de montage (10).

3. Dispositif de montage selon l'une quelconque des revendications précédentes,
**caractérisé en ce que**
les mouvements de plusieurs portiques (60) peuvent être synchronisés entre eux.

4. Dispositif de montage selon l'une quelconque des revendications précédentes,
**caractérisé en ce que**
la tête de montage (66) se compose d'une tête revolver disposée verticalement ou horizontalement.

5. Dispositif de montage selon l'une quelconque des revendications précédentes,
**caractérisé en ce que**
trois portiques ou plus sont disposés superposés.
